# EUROPEAN PATENT SPECIFICATION

(11) **EP 2 757 596 B1**
(45) Date of publication and mention of the grant of the patent: **28.09.2016**
(21) Application number: 14000128.0
(22) Date of filing: 14.01.2014
(51) Int. Cl.: H01L 31/18, H01L 31/068

(54) **Method for solar cell manufacturing**
Verfahren zur Solarzellenherstellung
Procédé de fabrication d'une cellule solaire

(30) Priority: 16.01.2013 KR 20130004935
(43) Date of publication of application: 23.07.2014
(73) Proprietor: LG Electronics, Inc., Seoul, 150-721 (KR)
(72) Inventor: Yang, Dohwan, 137-724 Seoul (KR); Yang, Juhong, 137-724 Seoul (KR); Jung, Ilhyoung, 137-724 Seoul (KR); Kim, Jinah, 137-724 Seoul (KR)
(74) Representative: Frenkel, Matthias Alexander

(56) References cited:
- WO-A1-2013/000026
- US-A1- 2009 227 095
- US-A1- 2012 032 310
- S. GALL ET AL: "High Quality Passivation Scheme Combined with Laser Doping from SiN:P and SiN:B Layer for Silicon Solar Cell", ENERGY PROCEDIA, vol. 27, 3 May 2012 (2012-05-03), - 5 May 2012 (2012-05-05), pages 467-473, XP055159896, ISSN: 1876-6102, DOI: 10.1016/j.egypro.2012.07.095
- GALL S ET AL: 'Evaluation of N-rich, P and B containing SiNx materials as passivation layer for silicon solar cell' PROCEEDINGS OF THE 26TH EUROPEAN PHOTOVOLTAIC SOLAR ENERGY CONFERENCE AND EXHIBITION 05 September 2011 - 09 September 2011, HAMBURG, GERMANY, CONFERENCE 5 - 9 SEPTEMBER 2011, pages 1648 - 1652, XP040637431 ISBN: 978-3-936338-27-0
- BOCK R ET AL: 'Back-junction back-contact n-type silicon solar cells with screen-printed aluminum-alloyed emitter' APPLIED PHYSICS LETTERS vol. 96, no. 26, 28 June 2010, pages 263507-1 - 263507-3, XP012131787 DOI: 10.1063/1.3456536 ISSN: 0003-6951
- REICHEL C ET AL: "Decoupling charge carrier collection and metallization geometry of back-contacted back-junction silicon solar cells by using insulating thin films", 35TH IEEE PHOTOVOLTAIC SPECIALISTS CONFERENCE (PVSC), 20-25 JUNE 2010, HONOLULU, HI, USA, IEEE, PISCATAWAY, NJ, USA, 20 June 2010 (2010-06-20), pages 1034-1038, XP031784356, ISBN: 978-1-4244-5890-5

## Description

This application claims priority to and the benefit of Korean Patent Application No. 10-2013-0004935 filed in the Korean Intellectual Property Office on January 16, 2013.

### BACKGROUND OF THE INVENTION

### Field of the Invention

Embodiments of the invention relate to a method for manufacturing a solar cell as defined if the independent claim.

### Description of the Related Art

Recently, as existing energy sources such as petroleum and coal are expected to be depleted, interests in alternative energy sources for replacing the existing energy sources are increasing. Among the alternative energy sources, solar cells for generating electric energy from solar energy have been particularly spotlighted.

A solar cell generally includes semiconductor parts, which respectively have different conductive types, for example, a p-type and an n-type and thus form a p-n junction, and electrodes respectively connected to the semiconductor parts of the different conductive types.

When light is incident on the solar cell, a plurality of electron-hole pairs are produced in the semiconductor parts. The electron-hole pairs are separated into electrons and holes. The electrons move to the n-type semiconductor part, and the holes move to the p-type semiconductor part under the influence of the p-n junction of the semiconductor parts. Then, the electrons and the holes are collected by the different electrodes respectively connected to the n-type semiconductor part and the p-type semiconductor part. The electrodes are connected to each other using electric wires to thereby obtain electric power.

Document "High Quality Passivation Scheme Combined with Laser Doping from SiN:P and SiN:B Layer for Silicon Solar Cell", S. Gall et.al., ENERGY PROCEDIA, vol. 27, 3 May 2012 to 5 May 2012, pages 467 to 473, may be construed to disclose a technique pertaining to passivation level of surface depleted n⁺ emitter with SiN:P and SiN:B. With the objective of improving the passivation quality, an SiO₂-base interfacial layer is added between the substrate and the doped layer. Moreover, effective laser doping occurs from both SiN:P and SiN:B through passivation layer to form n⁺ and p⁺ doped areas with controlled surface concentration and depth.

Document US2012/0032310 A1 may be construed to disclose a process for producing a semiconductor device comprising the following process steps: provision of a semiconductor substrate; formation of a functional layer on a semiconductor surface of the semiconductor substrate; and production of at least one doped section on the semiconductor surface by driving a dopant into the semiconductor substrate from the functional layer. The functional layer is formed in such a way that it passivates the semiconductor surface, acting as a passivation layer upon completion of the semiconductor device.

Document "EVALUATION OF N-RICH, P AND B CONTAINING SINX MATERIALS AS PASSIVATION LAYER FOR SILICON SOLAR CELL", S. Gall et.al.,

Proceedings of the 26th European Photovoltaic Solar Energy Conference and Exhibition, pages 1648 to 1652 may be construed to disclose a technique pertaining to increasing passivation quality of POCI3 diffused emitters. For this goal, three strategies are investigated: (i) reducing the surface concentration of dopant on initial emitter by etch-back, (ii) growing N-rich SiNx layer by tuning NH3/SiH4 flow during deposition, and (iii) introducing dopant precursors (PH3 or TMB) during deposition to grow either SiN(P) or SiN(B) materials.

"Back-junction back-contact n-type silicon solar cells with screen-printed aluminum-alloyed emitter", R. Bock et.al., Applied Physics Letter vol. 96, no. 26 may be construed to disclose an *n*-type Si back-junction back-contact solar cell based on an Al-doped *p*+ rear emitter fabricated by means of screen-printing and firing instead of the commonly applied high-temperature boron diffusion.

"DECOUPLING CHARGE CARRIER COLLECTION AND METALLIZATION GEOMETRY OF BACK-CONTACTED BACK-JUNCTION SILICON SOLAR CELLS BY USING INSULATING THIN FILMS", C. Reichel et.al., Proceedings of the 35th Photovoltaic Specialists Conference, pages 1034 to 1038 may be construed to disclose back-contacted back-junction silicon solar cell structures with a large emitter coverage (point-like base contacts) and a small emitter coverage (point-like emitter and base contacts). These solar cells feature an insulating thin film in order to decouple the charge carrier collection and the metallization geometry. It has been found that 200 nm thick ALD Al₂O₃ and 1000 nm thick PECVD SiO_{X} insulating films are suitable for both solar cell structures and that ALD layers are already insulating for a thinner film thickness. These insulating thin films have been applied to back-contacted back-junction silicon solar cells.

WO 2013/000026 A1 may be construed to disclose a dielectric, structure and a method of forming a dielectric structure for a rear surface of a silicon solar cell. The method comprises forming a first dielectric layer over the rear surface of the silicon solar cell, and then depositing a layer of metal such as aluminium over the first dielectric layer. The metal layer is then anodized to form a porous layer and a material layer is deposited over a surface of the porous layer such that the material deposits on the surface of the porous layer without contacting the silicon surface.

### SUMMARY OF THE INVENTION

According to the invention, there is provided a method for manufactoring a solar cell according to the independent claim. Developments are set forth in the dependent claims.

In one example, there is disclosed a method for manufacturing a solar cell including forming an emitter region containing impurities of a second conductive type opposite a first conductive type at a back surface of a semiconductor substrate containing impurities of the first conductive type, forming a passivation layer containing impurities of the first conductive type on the emitter region, selectively performing a thermal process on a first partial area of the passivation layer to form a back surface field region containing impurities of the first conductive type at a partial area of the emitter region, forming a plurality of openings in a second partial area of the passivation layer positioned on the emitter region and a third partial area of the passivation layer positioned on the back surface field region, forming a first electrode connected to the emitter region, and forming a second electrode connected to the back surface field region.

In the forming of the passivation layer, a concentration of the impurities of the first conductive type contained in the passivation layer is higher than a concentration of the impurities of the second conductive type contained in the emitter region.

The passivation layer preferably contains aluminum oxide (AlOx).

In the forming of the passivation layer, a formation thickness of the passivation layer preferably is 10 nm to 25 nm.

The forming of the back surface field region preferably includes diffusing the impurities of the first conductive type contained in the passivation layer into the partial area of the emitter region by selectively irradiating a laser beam onto the partial area of the passivation layer to form the back surface field region.

The forming of the emitter region preferably includes diffusing impurities of the second conductive type into the back surface of the semiconductor substrate using a process gas containing impurities of the second conductive type in a diffusion furnace. In this instance, the emitter region is preferably formed at a process temperature of 800 °C to 900 °C, and the process gas includes POCl₃ gas.

The forming of the plurality of openings in the passivation layer preferably includes-selectively irradiating a laser beam onto the second partial area of the passivation layer positioned on the emitter region and the third partial area of the passivation layer positioned on the back surface field region to form the plurality of openings.

A power of the laser beam used to form the plurality of openings in the passivation layer is preferably greater than a power of the laser beam used to form the back surface field region.

The forming of the plurality of openings in the passivation layer may include forming a mask having a plurality of openings on the passivation layer, and etching the first and second partial areas of the passivation layer exposed through the plurality of openings of the mask to form the plurality of openings in the passivation layer.

A solar cell is also disclosed, which does not form part of the invention and is not covered by the claims, inluding a semiconductor substrate containing impurities of a first conductive type, an emitter region which is positioned at a partial area of a back surface of the semiconductor substrate and contains impurities of a second conductive type opposite the first conductive type, a back surface field region which is positioned at a remaining partial area of the back surface of the semiconductor substrate and contains impurities of the first conductive type at a concentration higher than the semiconductor substrate, a passivation layer which is positioned on the emitter region and the back surface field region, has a plurality of openings exposing the emitter region and the back surface field region, and contains impurities of the first conductive type, a first electrode connected to the emitter region, and a second electrode connected to the back surface field region.

The passivation layer preferably contains aluminum oxide (AlOx), and a thickness of the passivation layer is 10 nm to 25 nm.

A concentration of the impurities of the first conductive type contained in the passivation layer is higher than a concentration of the impurities of the second conductive type contained in the emitter region.

According to the above-described, the passivation layer is used as a dopant injection source of the back surface field region, and at the same time may be used as the passivation layer of the solar cell. Hence, the method for manufacturing the solar cell may be further silmplified.

In addition, the method of the invention uses the laser process to form the back surface field region having a p-type semiconductor region, instead of exposing the semiconductor substrate in the diffusion furnace at a relatively high temperature for a long time. As a result, a reduction in characteristics of the semiconductor substrate may be minimized, and the efficiency of the solar cell may be further improved.

### BRIEFS DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:
FIGS. 1 and 2 illustrate a solar cell according to an example not forming part of the invention; and
FIGS. 3 to 9 illustrate a method for manufacturing a solar cell according to the invention.

### DETAILED DESCRIPTION OF THE EMBODIMENTS

Reference will now be made in detail to embodiments of the invention, examples of which are illustrated in the accompanying drawings. This invention may, however, be embodied in many different forms and should not be construed as limited to the embodiments set forth herein. Wherever possible, the same reference numbers will be used throughout the drawings to refer to the same or like parts. It will be paid attention that a detailed description of known arts will be omitted if it is determined that the known arts can obscure the embodiments of the invention.

In the drawings, the thickness of layers, films, panels, regions, etc., are exaggerated for clarity. It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, it will be understood that when an element such as a layer, film, region, or substrate is referred to as being "entirely" on other element, it may be on the entire surface of the other element and may not be on a portion of an edge of the other element.

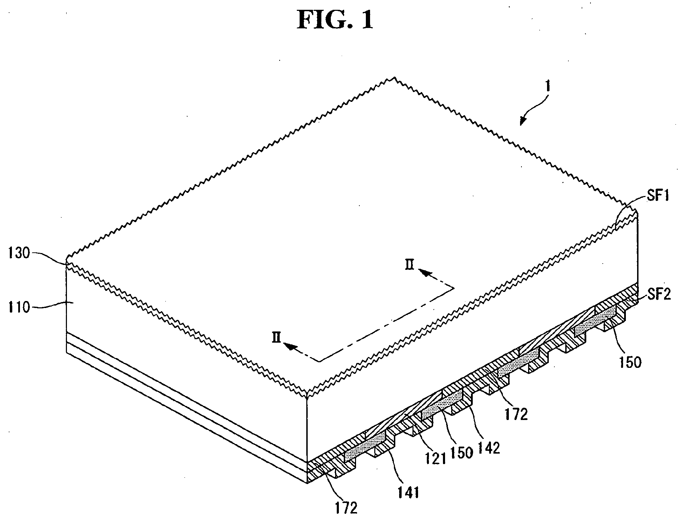

Exemplary embodiments of the invention will be described with reference to FIGS. 1 to 9.

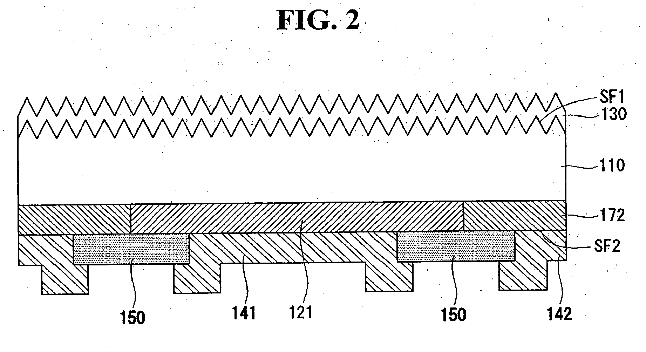

FIGS. 1 and 2 illustrate a solar cell according to an example not forming part of the invention. More specifically, FIG. 1 is a partial perspective view of such a solar cell, and FIG. 2 is a cross-sectional view taken along line II-II of FIG. 1.

As shown in FIGS. 1 and 2, solar cell 1 includes a semiconductor substrate 110, an anti-reflection layer 130 positioned on a first surface SF1 (for example, a front surface) of the semiconductor substrate 110, a plurality of emitter regions 121 positioned at a second surface SF2 (for example, a back surface) opposite the first surface SF1 of the semiconductor substrate 110, a plurality of back surface field (BSF) regions 172 which are positioned on the second surface SF2 of the semiconductor substrate 110 and extend in parallel with the plurality of emitter regions 121, a plurality of first electrodes 141 respectively positioned on the plurality of emitter regions 121, a plurality of second electrodes 142 respectively positioned on the plurality of back surface field regions 172, and passivation layer 150, positioned between the first and second electrodes 141 and 142 on the second surface SF2 of the semiconductor substrate 110. The solar cell 1 may include the anti-reflection layer 130 as an example. However, the anti-reflection layer 130 may be omitted, if necessary or desired.

As shown in FIGS. 1 and 2, when the anti-reflection layer 130 is formed, a photoelectric efficiency of the solar cell 1 may be further improved. Therefore, in the following description, the solar cell 1 including the anti-reflection layer 130 is described as an example.

The semiconductor substrate 110 may be a crystalline semiconductor substrate formed of first conductive type silicon, for example, n-type silicon, though not required. Silicon used in the semiconductor substrate 110 may be crystalline silicon such as single crystal silicon and polycrystalline silicon. When the semiconductor substrate 110 is of an n-type, the semiconductor substrate 110 may be doped with impurities of a group V element such as phosphorus (P), arsenic (As), and antimony (Sb). Alternatively, the semiconductor substrate 110 may be of a p-type and/or may be formed of a semiconductor material other than silicon. If the semiconductor substrate 110 is of the p-type, the semiconductor substrate 110 may be doped with impurities of a group III element such as boron (B), gallium (Ga), and indium (In).

An incident surface (for example, the front surface SF1) of the semiconductor substrate 110 is textured to form a textured surface corresponding to an uneven surface or having uneven characteristics. FIG. 1 shows that only an edge of the semiconductor substrate 110 has the textured surface for the sake of brevity and ease of description. However, the entire front surface SF1 of the semiconductor substrate 110 substantially has the textured surface, and thus the anti-reflection layer 130 positioned on the front surface SF1 of the semiconductor substrate 110 has the textured surface.

Alternatively, unlike the structure shown in FIGS. 1 and 2, the back surface SF2 as well as the front surface SF1 of the semiconductor substrate 110 may have the textured surface. In the following description, the solar cell 1, in which only the front surface SF1 of the semiconductor substrate 110 has the textured surface, is described as an example.

The anti-reflection layer 130 positioned on the front surface SF1 of the semiconductor substrate 110 increases selectivity of a predetermined wavelength band of light incident on the solar cell 1 and reduces a reflectance of the incident light. Further, the anti-reflection layer 130 performs a passivation function, which reduces a defect, for example, dangling bonds existing at and around the front surface SF1 of the semiconductor substrate 110 to thereby prevent or reduce a recombination and/or a disappearance of carriers (i.e., electrons or holes) moving to the front surface SF1 of the semiconductor substrate 110.

As a result, the anti-reflection layer 130 may increase the efficiency of the solar cell 1. The anti-reflection layer 130 may be formed using at least one of silicon oxide (SiOx), silicon oxynitride (SiOxNy), silicon nitride (SiNx), zinc oxide (ZnO), and aluminum zinc oxide (AZOx). Other materials may be used for the anti-reflection layer 130.

FIGS. 1 and 2 show the anti-reflection layer 130 having a single-layered structure. However, the anti-reflection layer 130 may have a multi-layered structure, for example, a double-layered structure.

The plurality of emitter regions 121 and the plurality of back surface field regions 172 are alternately positioned on the back surface SF2 of the semiconductor substrate 110 and extend in parallel with each other in a fixed direction.

Each emitter region 121 is formed on the back surface SF2 of the semiconductor substrate 110 and has a second conductive type (for example, p-type) opposite the first conductive type (for example, n-type) of the semiconductor substrate 110. Hence, the emitter regions 121 of the second conductive type form a p-n junction along with the semiconductor substrate 110 of the first conductive type.

Carriers, i.e., a plurality of electron-hole pairs produced by light incident on the semiconductor substrate 110 are separated into electrons and holes due to the p-n junction between the semiconductor substrate 110 and the emitter regions 121. The electrons move to the n-type semiconductor, and the holes move to the p-type semiconductor. Thus, when the semiconductor substrate 110 is of the n-type and the emitter regions 121 are of the p-type, the separated holes move to the emitter regions 121, and the separated electrons move to the back surface field regions 172 having an impurity concentration higher than the semiconductor substrate 110. Because the emitter regions 121 form the p-n junction along with the semiconductor substrate 110, the emitter regions 121 may be of the n-type when the semiconductor substrate 110 is of the p-type. In this instance, the separated electrons move to the emitter regions 121, and the separated holes move to the back surface field regions 172.

When the emitter regions 121 are of the p-type, the emitter regions 121 may be doped with impurities of a group III element such as B, Ga, and In. On the contrary, when the emitter regions 121 are of the n-type, the emitter regions 121 maybe doped with impurities of a group V element such as P, As, and Sb.

The emitter regions 121 are formed by diffusing impurities of the second conductive type into the back surface SF2 of the semiconductor substrate 110.

Each of the back surface field regions 172 is a region (for example, an n⁺-type region) which is more heavily doped than the semiconductor substrate 110 with impurities of the same conductive type as the semiconductor substrate 110. For example, when the semiconductor substrate 110 contains n-type impurities, each back surface field region 172 is an n⁺-type region.

The back surface field regions 172 are disposed at the back surface SF2 of the semiconductor substrate 110 and extend in a fixed direction in parallel with the emitter regions 121. As shown in FIGS. 1 and 2, the back surface field regions 172 and the emitter regions 121 maybe formed to contact each other.

A potential barrier is formed by a difference between impurity concentrations of the semiconductor substrate 110 and the back surface field regions 172. The potential barrier prevents or reduces holes from moving to the back surface field regions 172 used as a moving path of electrons and makes it easier for electrons to move to the back surface field regions 172. Thus, the back surface field regions 172 reduce an amount of carriers lost by a recombination and/or a disappearance of the electrons and the holes at and around the back surface field regions 172 or at and around the first and second electrodes 141 and 142, and accelerate a movement of desired carriers (for example, electrons), thereby increasing the movement of carriers to the back surface field regions 172.

The plurality of first electrodes 141 are respectively positioned on the plurality of emitter regions 121, extend along the emitter regions 121, and are electrically and physically connected to the emitter regions 121. Each first electrode 141 collects carriers (for example, holes) moving to the corresponding emitter region 121.

The plurality of second electrodes 142 are respectively positioned on the plurality of back surface field regions 172, extend along the back surface field regions 172, and are electrically and physically connected to the back surface field regions 172. Each second electrode 142 collects carriers (for example, electrons) moving to the corresponding back surface field region 172.

The first and second electrodes 141 and 142 may be formed of a conductive metal material, for example, at least one conductive metal material selected from the group consisting of nickel (Ni), copper (Cu), silver (Ag), aluminum (Al), tin (Sn), zinc (Zn), indium (In), titanium (Ti), gold (Au), and a combination thereof. Other materials may be used. For example, the first and second electrodes 141 and 142 may be formed of a transparent conductive metal containing transparent conductive oxide (TCO).

Passivation layer 150 is positioned between the first and second electrodes 141 and 142 on the second surface SF2 of the semiconductor substrate 110. Namely, passivation layer 150 is formed to contact both the emitter region 121 and the back surface field region 172.

Passivation layer 150 insulates the first electrode 141 from the second electrode 142 and also performs a passivation function, which reduces a defect, for example, dangling bonds existing at and around the front surface SF1 of the semiconductor substrate 110 to thereby prevent or reduce a recombination and/or a disappearance of carriers (i.e., electrons or holes) moving to the front surface SF1 of the semiconductor substrate 110.

An operation of the solar cell 1 having the above-described structure is described below.

When light irradiated onto the solar cell 1 is incident on the semiconductor substrate 110, a plurality of electron-hole pairs are generated in the semiconductor substrate 110 by light energy produced by the light incident on the semiconductor substrate 110. The electron-hole pairs are separated into electrons and holes by the p-n junction between the semiconductor substrate 110 and the emitter regions 121. The separated electrons move to the n-type semiconductor substrate 110, and the separated holes move to the p-type emitter regions 121. Then, the electrons moving to the semiconductor substrate 110 are transferred to the second electrodes 142 and are collected by the second electrodes 142, and the holes moving to the emitter regions 121 are transferred to the first electrodes 141 and are collected by the first electrodes 141. When the first electrodes 141 are connected to the second electrodes 142 using electric wires, electric current flows therein to thereby enable use of the current for electric power.

The passivation layer 150 may contain a non-conductive insulating material and may contain impurities of the same conductive type as the semiconductor substrate 110, so as to reduce a manufacturing time of the solar cell 1 and prevent a reduction in characteristics of the semiconductor substrate 110.

For example, if the semiconductor substrate 110 contains p-type impurities, the emitter regions 121 contain n⁺-type impurities, and the back surface field regions 172 contain p⁺-type impurities, the passivation layer 150 may contain p-type impurities of the same conductive type as the back surface field regions 172. In this instance, it is preferable, but not required, that passivation layer 150 is formed of aluminum oxide (AlOx) containing aluminum as the p-type impurities and has a thickness of about 10 nm to 25 nm.

A concentration of the impurities contained in the passivation layer 150 is higher than a concentration of the impurities contained in the emitter region 121.

For example, when the semiconductor substrate 110 contains p-type impurities, the emitter regions 121 contain n⁺-type impurities, the back surface field regions 172 contain p⁺-type impurities, and the passivation layers 150 contain p-type impurities, a concentration of the p-type impurities contained in the passivation layer 150 is higher than a concentration of the n⁺-type impurities contained in the emitter region 121.

An effect of the passivation layer 150 is described in detail through a method for manufacturing the solar cell 1 according the invention.

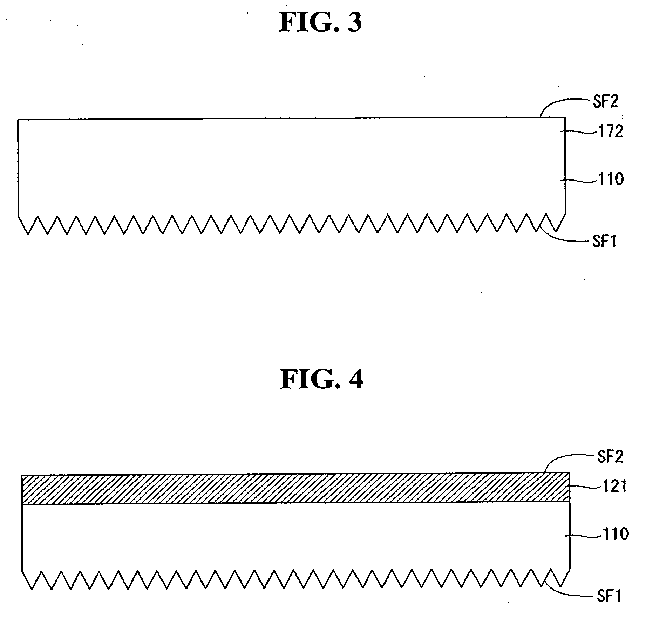

FIGS. 3 to 9 illustrate a method for manufacturing a solar cell according to the invention.

As shown in FIG. 3, a semiconductor substrate 110 containing impurities of a first conductive type or impurities of a second conductive type opposite the first conductive type is provided. For example, the semiconductor substrate 110 may be a semiconductor substrate containing p-type impurities or n-type impurities.

It is preferable, but not required, that a front surface SF1 of the semiconductor substrate 110 is textured.

Next, as shown in FIG. 4, an emitter region 121 containing impurities of the second conductive type is formed at an entire back surface SF2 of the semiconductor substrate 110. For example, the emitter region 121 is formed as an n⁺-type region which highly contains n-type impurities as the impurities of the second conductive type.

The emitter region 121 is formed by diffusing the impurities of the second conductive type into the entire back surface SF2 of the semiconductor substrate 110 at a process temperature of about 800 °C to 900 °C using a process gas (for example, POCl₃ gas) containing the impurities of the second conductive type in a diffusion furnace.

As described above, because the process for forming the emitter region 121 containing the n-type impurities is performed at the relatively low temperature, carrier lifetime, which is one of characteristics of the semiconductor substrate 110, is scarcely reduced.

When the semiconductor substrate 110 in the diffusion furnace is exposed at a temperature equal to or higher than about 1,000 °C for a long time (for example, about 1 hour) so as to inject impurities into the semiconductor substrate 110, the carrier lifetime of the semiconductor substrate 110 may be affected. However, when the emitter region 121 containing the impurities of the second conductive type is formed at the entire back surface SF2 of the semiconductor substrate 110 using POCl₃ gas, the carrier lifetime of the semiconductor substrate 110 is scarcely reduced as described above because the process temperature is relatively low.

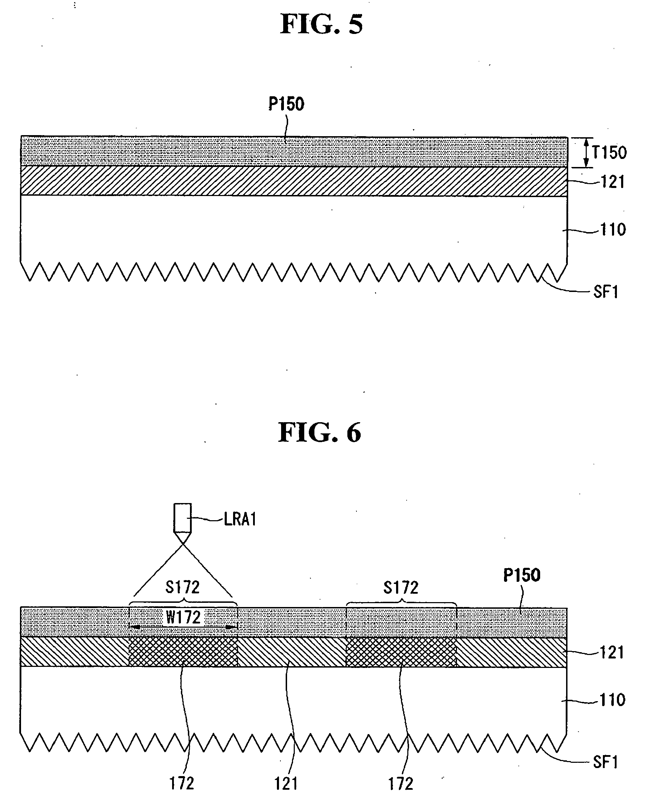

Next, as shown in FIG. 5, a passivation layer P150 containing impurities of the same conductive type (i.e., the first conductive type) as the semiconductor substrate 110 is formed on the emitter region 121 containing the impurities of the second conductive type.

More specifically, the passivation layer P150 containing the impurities of the first conductive type is applied to the emitter region 121 using an application method or a deposition method and then is dried at a relatively low temperature (for example, a temperature equal to or lower than about 200 °C).

The passivation layer P150 thus formed may serve as a dopant source, which is an injection source of the impurities of the first conductive type, when a back surface field region 172 containing the impurities of the first conductive type is formed in a subsequent process, and also may passivate the back surface SF2 of the semiconductor substrate 110.

A concentration of the impurities of the first conductive type contained in the passivation layer P150 is higher than a concentration of the impurities of the second conductive type contained in the emitter region 121.

A reason why the concentration of the impurities of the first conductive type contained in the passivation layer P150 is higher than the concentration of the impurities of the second conductive type contained in the emitter region 121 is that when the impurities of the first conductive type contained in the passivation layer P150 are injected into the emitter region 121, which has been already formed, in a subsequent process, the impurities of the first conductive type are injected at a concentration higher than the concentration of the impurities of the second conductive type contained in the emitter region 121 to form the back surface field region 172 containing the impurities of the first conductive type through the overcompensation.

For example, the passivation layer P150 is formed using aluminum oxide (AlOx) containing aluminum as the impurities of the first conductive type. It is preferable, but not required, that the passivation layer P150 has a thickness T150 of about 10 nm to 25 nm.

In the embodiment of the invention, when the thickness-T150 of the passivation layer P150 is equal to or greater than about 10 nm, a passivation function of the passivation layer P150 may be smoothly performed, and the concentration of the impurities of the first conductive type contained in the passivation layer P150 may be maintained at a sufficient level. Hence, when a portion S172 of the emitter region 121 is converted into the back surface field region 172 in a subsequent process, the overcompensation of the impurities of the first conductive type may be sufficiently performed.

Further, when the thickness T150 of the passivation layer P150 is equal to or less than about 25 nm, the passivation function and the overcompensation function of the passivation layer P150 may be sufficiently performed. Hence, the consumption of an unnecessary material may be minimized.

Next, as shown in FIG. 6, a thermal process is selectively performed on the portion S172 of the passivation layer P150 to form the back surface field region 172 containing the impurities of the first conductive type at the portion S 172 of the emitter region 121.

More specifically, the embodiment of the invention selectively performs the thermal process on the portion S172 of the passivation layer P150 and diffuses the first conductive type impurities of a high concentration contained in the passivation layer P150 into the portion S172 of the emitter region 121 containing the second conductive type impurities to perform the overcompensation of the first conductive type impurities of the high concentration on the portion S 172 of the emitter region 121. Hence, the portion S 172 of the emitter region 121 is formed as (or changed into) the back surface field region 172 containing the first conductive type impurities.

For example, the selective thermal process on the portion S172 of the passivation layer P150 may be performed by irradiating a laser beam having a wavelength of about 532 nm using a first laser irradiation device LRA1 or selectively (or partially) irradiating a femtosecond laser beam onto the portion S 172 of the passivation layer P150.

Hence, the first conductive type impurities of the high concentration contained in the portion S 172 of the passivation layer P150, onto which the laser beam is irradiated, are diffused and injected into the portion S172 of the emitter region 121. The characteristics of the emitter region 121 obtained by the second conductive type impurities of a low concentration, which has been already contained in the emitter region 121, disappear by the overcompensation of the first conductive type impurities of the high concentration of the passivation layer P150. As a result, the portion S172 has characteristics obtained by only the first conductive type impurities to form the back surface field region 172 containing the impurities of the first conductive type.

As described above, the diffusion process performed at a high temperature and the formation of oxide used as a barrier in the diffusion process are not required to form the back surface field region 172. Therefore, the carrier lifetime may be prevented from being reduced by the thermal process.

More specifically, when the p-type impurities as a dopant are diffused into the semiconductor substrate 110 in the diffusion furnace to form the back surface field region 172 in a conventional process, BBr₃ gas is generally used as the process gas. In this instance, a temperature of a process for injecting boron (B) into the semiconductor substrate 110 in the diffusion furnace has to be about 1,050 °C, and an exposure time has to be about 1 hour or longer. Thus, the semiconductor substrate 110 is greatly affected by the thermal process, and the carrier lifetime is greatly reduced. As a result, the efficiency of the solar cell 1 is reduced.

On the other hand, in the method of the invention, because the thermal process is selectively performed only on a portion of the semiconductor substrate 110 using a laser beam, so that the entire semiconductor substrate 110 is not exposed to an environment of the high temperature, a reduction in the characteristics of the semiconductor substrate 110 may be minimized.

Referring again to FIG. 6, the back surface field regions 172 containing the impurities of the first conductive type and the emitter regions 121 containing the impurities of the second conductive type are formed at the back surface SF2 of the semiconductor substrate 110. The back surface field region 172 and the emitter region 121 are positioned adjacent to each other. Further, the back surface field region 172 and the emitter region 121 are formed in the same pattern as FIGS. 1 and 2.

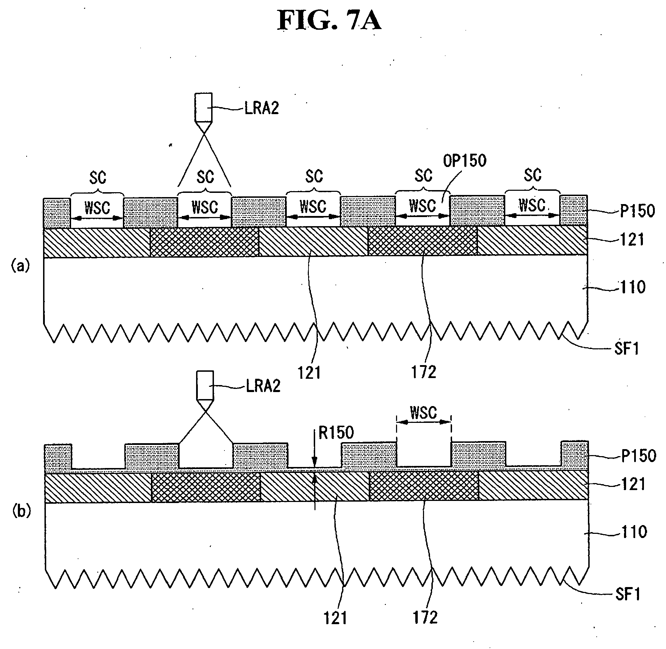

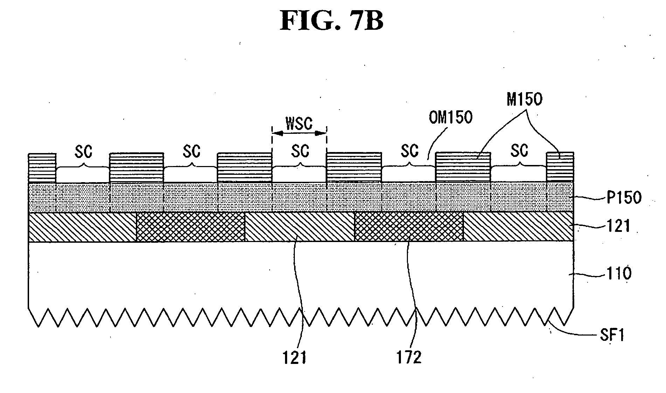

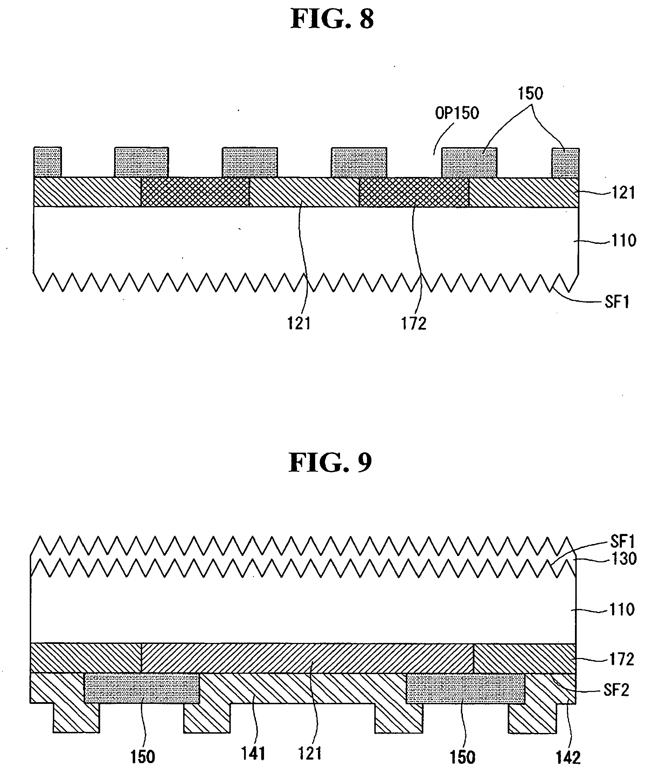

Next, as shown in FIGS. 7A and 7B, partial areas SC of the passivation layer P150 positioned on the emitter regions 121 and the back surface field regions 172 are etched. Hence, as shown in FIG. 8, a passivation layer 150 having a plurality of openings OP150, through which the emitter regions 121 and the back surface field regions 172 are exposed, is formed.

Various known methods including a method using a laser beam and a wet etching method using a mask may be used to form the plurality of openings OP 150 in the passivation layer P150.

First, as shown in FIG. 7A, the method using the laser beam is to selectively irradiate a laser beam onto the partial area SC of the passivation layer P150 positioned on the emitter region 121 and the partial area SC of the passivation layer P150 positioned on the back surface field region 172 using a second laser irradiation device LRA2 to form the plurality of openings OP150 in the passivation layer P150.

In this instance, as shown in (a) of FIG. 7A, the plurality of openings OP 150 may be formed in the partial area SC of the passivation layer P150 using only the laser beam. However, as shown in (b) of FIG. 7A, to minimize a reduction in the characteristics of the semiconductor substrate 110 resulting from the laser beam, the laser beam may be selectively irradiated onto the partial area SC of the passivation layer P150 to form a plurality of grooves so that a minimum thickness R150 of each groove (i.e., laser irradiation area) is equal to or less than several nanometers to the extent that the openings OP150 are not formed in (or do not punch through) the passivation layer P150. Then, the passivation layer P150 remaining in the grooves (with a minimum thickness R150) may be wet-etched and removed to form the openings OP150 in the passivation layer P150.

In this instance, it is preferable, but not required, that a width WSC of each of the plurality of openings OP150 is less than a width W 172 of each of the back surface field regions 172. Hence, a position of a boundary surface between the back surface field region 172 and the emitter region 121 may overlap a position of the passivation layer 150.

The laser beam output from the second laser irradiation device LRA2 used to form the plurality of openings OP150 in the passivation layer P150 has to etch the partial area SC of the passivation layer P150. Therefore, power of the laser beam output from the second laser irradiation device LRA2 is greater than the power of the laser beam output from the first laser irradiation device LRA1 used to form the back surface field regions 172.

Further, as shown in FIG. 7B, an etching method using a mask M150 may be used to form the plurality of openings OP150 in the passivation layer P150.

More specifically, as shown in FIG. 7B, the mask M150 having a plurality of openings OM150 is formed on the passivation layer P150, and then the partial area SC of the passivation layer P150 exposed by the openings OM150 of the mask M150 is etched. Hence, the plurality of openings OP150 are formed in the passivation layer P150.

As shown in FIG. 8, a pattern of the passivation layer 150 may be positioned on the boundary surface between the back surface field region 172 and the emitter region 121. Namely, the passivation layer 150 may have the pattern, in which partial areas of the back surface field regions 172 and partial areas of the emitter regions 121 are alternately exposed through the plurality of openings OP150 formed in the passivation layer 150.

Next, as shown in FIG. 9, a plurality of first electrodes 141 connected to the emitter regions 121 through the openings OP150 of the passivation layer 150 are formed, and a plurality of second electrodes 142 connected to the back surface field regions 172 through the openings OP150 of the passivation layer 150 are formed.

The first electrodes 141 and the second electrodes 142 may be formed using a screen printing method or a plating method. However, it is preferable, but not required, that the plating method is used to form the first electrodes 141 and the second electrodes 142 in consideration of an influence on the characteristics (for example, the carrier lifetime) of the semiconductor substrate 110 in an alignment process.

Further, an anti-reflection layer 130 is formed on the front surface SF1 of the semiconductor substrate 110. Hence, the solar cell 1 shown in FIGS. 1 and 2 is formed.

The method for manufacturing the solar cell 1 according to the invention may use the passivation layer P150 as the dopant injection source of the back surface field region 172, and at the same time may use the passivation layer P150 as the passivation layer 150 of the solar cell 1. Hence, the method for manufacturing the solar cell 1 according to the invention may be further simplified.

In addition, the method for manufacturing the solar cell 1 according the embodiment of the invention uses the laser process to form the back surface field region having a p-type semiconductor region, instead of exposing the semiconductor substrate in the diffusion furnace at the relatively high temperature for a long time. As a result, a reduction in the characteristics of the semiconductor substrate may be minimized, and the efficiency of the solar cell may be further improved.

Although embodiments have been described with reference to a number of illustrative embodiments thereof, it should be understood that numerous other modifications and embodiments can be devised by those skilled in the art that will fall within the scope of the appended claims. More particularly, various variations and modifications are possible in the component parts and/or arrangements of the subject combination arrangement within the scope of the appended claims.

## Claims

1. A method for manufacturing a solar cell (1) comprising:
forming an emitter region (121) containing impurities of a second conductive type opposite a first conductive type at an entire back surface (SF2) of a semiconductor substrate (110) containing impurities of the first conductive type;
forming a passivation layer (P150, 150) containing impurities of the first conductive type on the emitter region, wherein a concentration of the impurities of the first conductive type contained in the passivation layer is higher than a concentration of the impuritie the second conductive type contained in the emitter region, and the passivation layer (P150, 150) is positioned directly on the emitter region;
forming a back surface field, BSF, region (172) containing impurities of the first conductive type at a partial area of the emitter region by irradiating a laser beam (LRA1) onto a first partial area (S172) of the passivation layer;
forming a plurality of openings (OP150) in a second partial area (SC) of the passivation layer positioned on the emitter region and a third partial area (SC) of the passivation layer positioned on the BSF region;
forming a first electrode (141) connected to the emitter region through the plurality of openings (OP150) in the second partial area (SC) of the passivation layer; and
forming a second electrode (142) connected to the BSF region through the plurality of openings (OP150) in the third partial area (SC) of the passivation layer.

2. The method of claim 1, wherein the passivation layer contains aluminum oxide, AlOx.

3. The method of claim 1, wherein in the forming of the passivation layer, a formation thickness (T150) of the passivation layer is about 10 nm to 25 nm.

4. The method of claim 1, wherein the forming of the BSF region includes diffusing the impurities of the first conductive type contained in the passivation layer into the partial area of the emitter region.

5. The method of claim 1, wherein the emitter region is formed at a process temperature of 800 °C to 900 °C.

6. The method of claim 5, wherein the forming of the emitter region includes diffusing impurities of the second conductive type into the back surface of the semiconductor substrate using a process gas containing impurities of the second conductive type in a diffusion furnace.

7. The method of claim 6, wherein the process gas includes POCl₃ gas.

8. The method of claim 4, wherein the forming of the plurality of openings (OP150) in the passivation layer includes selectively irradiating a laser beam (LRA2) onto the second partial area of the passivation layer positioned on the emitter region and the third partial area of the passivation layer positioned on the BSF region to form the plurality of openings.

9. The method of claim 8, wherein the power of the laser beam (LRA2) used to form the plurality of openings in the passivation layer is greater than the power of the laser beam (LRA1) used to form the BSF region.

10. The method of claim 1, wherein the forming of the plurality of openings (OP150) in the passivation layer includes:
forming a mask (M150) having a plurality of openings (OM150) on the passivation layer; and
etching the first and second partial areas of the passivation layer exposed through the plurality of openings of the mask to form the plurality of openings in the passivation layer.

## Patentansprüche

1. Verfahren zum Herstellen einer Solarzelle (1), umfassend:
Ausbilden eines Emitterbereichs (121), der Verunreinigungen eines zweiten Leittyps entgegengesetzt einem ersten Leittyp umfasst, auf einer gesamten Rückoberfläche (SF2) eines Halbleitersubstrats (110), das Verunreinigungen des ersten Leittyps umfasst;
Ausbilden einer Passivierungsschicht (P150, 150), die Verunreinigungen des ersten Leittyps umfasst, auf dem Emitterbereich, wobei eine Konzentration der Verunreinigungen des ersten Leittyps, die in der Passivierungsschicht umfasst sind, höher als eine Konzentration der Verunreinigungen des zweiten Leittyps sind, die in dem Emitterbereich umfasst sind, und wobei die Passivierungsschicht (P150, 150) direkt auf dem Emitterbereich positioniert ist;
Ausbilden eines Rückoberflächenfeld-, BSF, -Bereichs (172), der Verunreinigungen des ersten Leittyps in einem Teilbereich des Emitterbereichs umfasst, indem ein Laserstrahl (LRA1) auf einen ersten Teilbereich (S172) der Passivierungsschicht gestrahlt wird;
Ausbilden einer Vielzahl von Öffnungen (OP150) in einem zweiten Teilbereich (SC) der Passivierungsschicht, der auf dem Emitterbereich positioniert ist, und eines dritten Teilbereichs (SC) der Passivierungsschicht, der auf dem BSF-Bereich positioniert ist;
Ausbilden einer ersten Elektrode (141), die mit dem Emitterbereich durch die Vielzahl von Öffnungen (OP150) verbunden ist, in dem zweiten Teilbereich (SC) der Passivierungsschicht; und
Ausbilden einer zweiten Elektrode (142), die mit dem BSF-Bereich durch die Vielzahl von Öffnungen (OP150) verbunden ist, in dem dritten Teilbereich (SC) der Passivierungsschicht.

2. Verfahren gemäß Anspruch 1, wobei die Passivierungsschicht Aluminiumoxid, AlOx, enthält.

3. Verfahren gemäß Anspruch 1, wobei, in dem Ausbilden der Passivierungsschicht, eine Ausbildungsdicke (T150) der Passivierungsschicht etwa 10 nm bis 25 nm beträgt.

4. Verfahren gemäß Anspruch 1, wobei das Ausbilden des BSF-Bereichs ein Zerstreuen der Verunreinigungen des ersten Leittyps, die in der Passivierungsschicht enthalten sind, in dem Teilbereich des Emitterbereichs umfasst.

5. Verfahren gemäß Anspruch 1, wobei der Emitterbereich bei einer Prozesstemperatur von 800°C bis 900°C ausgebildet wird.

6. Verfahren gemäß Anspruch 5, wobei das Ausbilden des Emitterbereichs ein Zerstreuen von Verunreinigungen des zweiten Leittyps in der Rückoberfläche des Halbleitersubstrats unter Verwendung eines Prozessgases umfasst, das Verunreinigungen des zweiten Leittyps umfasst, in einem Diffusionsofen.

7. Verfahren gemäß Anspruch 6, wobei das Prozessgas POCl₃-Gas enthält.

8. Verfahren gemäß Anspruch 4, wobei das Ausbilden der Vielzahl von Öffnungen (OP150) in der Passivierungsschicht ein selektives Bestrahlen eines Laserstrahls (LRA2) auf den zweiten Teilbereich der Passivierungsschicht, der auf dem Emitterbereich positioniert ist, und den dritten Teilbereich der Passivierungsschicht umfasst, der auf dem BSF-Bereich positioniert ist, um die Vielzahl von Öffnungen auszubilden.

9. Verfahren gemäß Anspruch 8, wobei die Leistung des Laserstrahls (LRA2), der zum Ausbilden der Vielzahl von Öffnungen in der Passivierungsschicht verwendet wird, größer als die Leistung des Laserstrahls (LRA1) ist, der zum Ausbilden des BSF-Bereichs verwendet wird.

10. Verfahren gemäß Anspruch 1, wobei das Ausbilden der Vielzahl von Öffnungen (OP150) in der Passivierungsschicht umfasst:
Ausbilden einer Maske (M150), die eine Vielzahl von Öffnungen (OM150) aufweist, auf der Passivierungsschicht; und
Ätzen des ersten und zweiten Teilbereichs der Passivierungsschicht, die durch die Vielzahl von Öffnungen der Maske bloßgelegt sind, um die Vielzahl von Öffnungen in der Passivierungsschicht auszubilden.

## Revendications

1. Procédé de fabrication d'une cellule solaire (1) comprenant :
la formation d'une région (121) d'émetteur contenant des impuretés d'un deuxième type de conductivité opposé à un premier type de conductivité au niveau de la totalité d'une surface arrière (SF2) d'un substrat semi-conducteur (110) contenant des impuretés du premier type de conductivité ;
la formation d'une couche (P150, 150) de passivation contenant des impuretés du premier type de conductivité sur la région d'émetteur, dans lequel une concentration des impuretés du premier type de conductivité contenues dans la couche de passivation est supérieure à une concentration des impuretés du deuxième type de conductivité contenues dans la région d'émetteur, et la couche (P150, 150) de passivation est positionnée directement sur la région d'émetteur ;
la formation d'une région (172) de champ de surface arrière, BSF, contenant des impuretés du premier type de conductivité au niveau d'une zone partielle de la région d'émetteur en projetant un faisceau laser (LRA1) sur une première zone partielle (S172) de la couche de passivation ;
la formation d'une pluralité d'ouvertures (OP150) dans une deuxième zone partielle (SC) de la couche de passivation positionnée sur la région d'émetteur et une troisième zone partielle (SC) de la couche de passivation positionnée sur la région de BSF ;
la formation d'une première électrode (141) connectée à la région d'émetteur à travers la pluralité d'ouvertures (OP150) dans la deuxième zone partielle (SC) de la couche de passivation ; et
la formation d'une deuxième électrode (142) connectée à la région de BSF à travers la pluralité d'ouvertures (OP150) dans la troisième zone partielle (SC) de la couche de passivation.

2. Procédé selon la revendication 1, dans lequel la couche de passivation contient un oxyde d'aluminium, AlOx.

3. Procédé selon la revendication 1, dans lequel, lors de la formation de la couche de passivation, une épaisseur (T150) de formation de la couche de passivation est environ 10 nm à 25 nm.

4. Procédé selon la revendication 1, dans lequel la formation de la région de BSF inclut la diffusion des impuretés du premier type de conductivité contenues dans la couche de passivation dans la région partielle de la région d'émetteur.

5. Procédé selon la revendication 1, dans lequel la région d'émetteur est formée à une température de procédé de 800 °C à 900 °C.

6. Procédé selon la revendication 5, dans lequel la formation de la région d'émetteur inclut la diffusion d'impuretés du deuxième type de conductivité dans la surface arrière du substrat semi-conducteur en utilisant un gaz de procédé contenant des impuretés du deuxième type de conductivité dans un four de diffusion.

7. Procédé selon la revendication 6, dans lequel le gaz de procédé inclut du gaz POCl₃.

8. Procédé selon la revendication 4, dans lequel la formation de la pluralité d'ouvertures (OP150) dans la couche de passivation inclut la projection sélective d'un faisceau laser (LRA2) sur la deuxième zone partielle de la couche de passivation positionnée sur la région d'émetteur et la troisième zone partielle de la couche de passivation positionnée sur la région de BSF pour former la pluralité d'ouvertures.

9. Procédé selon la revendication 8, dans lequel la puissance du faisceau laser (LRA2) utilisé pour former la pluralité d'ouvertures dans la couche de passivation est supérieure à la puissance du faisceau laser (LRA1) utilisé pour former la région de BSF.

10. Procédé selon la revendication 1, dans lequel la formation de la pluralité d'ouvertures (OP150) dans la couche de passivation inclut :
la formation d'un masque (M150) ayant une pluralité d'ouvertures (OM150) sur la couche de passivation ; et
la gravure des première et deuxième zones partielles de la couche de passivation exposées à travers la pluralité d'ouvertures du masque pour former la pluralité d'ouvertures dans la couche de passivation.
